# DEMANDE DE BREVET EUROPEEN

(11) **EP 4 757 546 A1**
(43) Date de publication de la demande: **10.06.2026**
(21) Numéro de dépôt: 25219953.4
(22) Date de dépôt: 02.12.2025
(51) Int. Cl.: H10H 20/01, H10H 20/817, H10H 20/855, H10H 29/01, H10H 29/14, H10H 29/855, H10H 29/24, H10H 20/831

(54) **PROCÉDÉ DE FABRICATION D'UN DISPOSITIF OPTOÉLECTRONIQUE COMPORTANT UNE DIODE RECOUVERTE PAR UN COMPOSANT OPTIQUE ET DISPOSITIF OPTOÉLECTRONIQUE EN RÉSULTANT**

(30) Priorité: 06.12.2024 FR 2413597
(71) Demandeur: Commissariat à l'Energie Atomique et aux Energies Alternatives, 75015 Paris (FR)
(72) Inventeur: ABADIE, Quentin, 38054 Grenoble Cedex 09 (FR); PERNEL, Carole, 38054 Grenoble Cedex 09 (FR); MICHIT, Nicolas, 38054 Grenoble Cedex 09 (FR); AUDIBERT, Margaux, 38054 Grenoble Cedex 09 (FR); VIVARES, Valentin, 38054 Grenoble Cedex 09 (FR)
(74) Mandataire: Santarelli

(57) **Abrégé**

L'invention porte sur un procédé de fabrication d'un dispositif optoélectronique (1) comportant au moins une diode (10) photoémettrice ou photoréceptrice présentant une face avant destinée à transmettre ou recevoir un rayonnement lumineux ; au moins un composant optique (50) de mise en forme du rayonnement lumineux, situé sur la face avant et recouvrant la diode, et présentant une variation latérale d'indice optique effectif (ñ) prédéfinie. Le procédé comporte les étapes suivantes : fournir la diode (10) ; déterminer une variation latérale d'un taux de porosité (p), à partir d'une variation latérale d'indice optique cible (n_{c}) prédéfinie, d'une portion semiconductrice réalisée en un matériau cristallin transparent au rayonnement lumineux et située sur la face avant et recouvrant la diode (10) ; réaliser la portion semiconductrice à porosifier ; effectuer une porosification électrochimique de la portion semiconductrice, de sorte qu'elle présente la variation latérale déterminée du taux de porosité (p), la portion semiconductrice ainsi porosifiée formant alors le composant optique (50).

## Description

### DOMAINE TECHNIQUE

Le domaine de l'invention est celui des dispositifs optoélectroniques comportant une matrice de diodes, lesquelles sont recouvertes par des composants optiques tels que des microlentilles.

### ÉTAT DE LA TECHNIQUE ANTÉRIEURE

Les dispositifs optoélectroniques peuvent être formés d'une matrice de diodes, par exemple des diodes électroluminescentes réalisées à base d'un matériau semiconducteur tel qu'un composé III-V, par exemple du GaN, où chaque diode est recouverte par une microlentille destinée à améliorer à l'extraction lumineuse et à mettre en forme le faisceau lumineux émis.

La réalisation des microlentilles comprend généralement une étape de structuration d'une résine photosensible par photolithographie, suivie d'une étape de fluage, et enfin de transfert par gravure dans un matériau transparent organique ou inorganique, par exemple dans du GaN. Ces microlentilles sont habituellement hémisphériques et centrosymétriques.

Toutefois, un tel procédé présente un certain nombre de limitations. Ainsi, il est relativement complexe, du fait notamment des étapes de fluage et de transfert de forme dans le matériau transparent. De plus, il offre peu de degrés de liberté dans le dimensionnement des microlentilles, ce qui limite le choix des propriétés optiques de mise en forme du faisceau lumineux. Par ailleurs, les microlentilles présentent une face avant courbe, de sorte que l'intégration d'éléments supplémentaires, optiques ou non, au-dessus des microlentilles, peut être compliquée.

### EXPOSÉ DE L'INVENTION

L'invention a pour objectif de remédier au moins en partie aux inconvénients de l'art antérieur. Pour cela, l'invention porte sur un procédé de fabrication d'un dispositif optoélectronique comportant au moins une diode, photoémissive ou photoréceptrice, recouverte par un composant optique présentant une variation latérale d'indice optique obtenue par porosification électrochimique.

Plus précisément, l'objet de l'invention est un procédé de fabrication d'un dispositif optoélectronique comportant : au moins une diode photoémettrice ou photoréceptrice présentant une face avant destinée à transmettre ou recevoir un rayonnement lumineux ; au moins un composant optique de mise en forme du rayonnement lumineux, situé sur la face avant et recouvrant la diode, et présentant une variation latérale d'indice optique prédéfini.

Le procédé de fabrication comporte les étapes suivantes : fournir la diode ; déterminer une variation latérale d'un taux de porosité, à partir d'une variation latérale d'indice optique cible prédéfinie, d'une portion semiconductrice réalisée en un matériau cristallin transparent au rayonnement lumineux et située sur la face avant et recouvrant la diode ; réaliser la portion semiconductrice à porosifier ; effectuer une porosification électrochimique de la portion semiconductrice, de sorte qu'elle présente la variation latérale déterminée du taux de porosité, la portion semiconductrice ainsi porosifiée formant alors le composant optique.

Certains aspects préférés mais non limitatifs de ce procédé de fabrication sont les suivants.

La portion semiconductrice à porosifier peut présenter une face supérieure plane opposée à la face avant de la diode.

Lors de l'étape de réalisation de la portion semiconductrice à porosifier, celle-ci peut comporter plusieurs zones dopées adjacentes, pouvant présenter un niveau de dopage différent d'une zone dopée à l'autre.

Lors de l'étape de porosification électrochimique, les zones dopées peuvent être porosifiées et peuvent présenter un taux de porosité différent d'une zone dopée à l'autre.

Lors de l'étape de réalisation de la portion semiconductrice à porosifier, chaque zone dopée peut présenter un niveau de dopage homogène latéralement et verticalement.

Le dispositif optoélectronique peut comporter une matrice de diodes et plusieurs composants optiques formés à partir de portions semiconductrices à porosifier. Lors de l'étape de réalisation des portions semiconductrice à porosifier, celles-ci peuvent être des parties d'une même couche semiconductrice continue pouvant s'étendre sur la matrice de diodes.

Lors de l'étape de porosification électrochimique, un signal électrique d'anodisation peut présenter une valeur constante dans le temps jusqu'à l'obtention de la variation latérale du taux de porosité.

Lors de l'étape de porosification électrochimique, une modulation en intensité d'un signal électrique d'anodisation peut être effectuée, pouvant conduire à l'obtention de la variation latérale latérale du taux de porosité.

Lors de l'étape de réalisation de la portion semiconductrice à porosifier, celle-ci peut présenter un niveau de dopage latéralement homogène.

Lors de l'étape de réalisation de la portion semiconductrice à porosifier, celle-ci peut présenter une bordure latérale libre.

Lors de l'étape de réalisation de la portion semiconductrice à porosifier, celle-ci peut présenter une face supérieure recouverte par une portion mince de protection réalisée en un matériau non porosifiable lors de l'étape de porosification électrochimique.

La portion semiconductrice à porosifier peut être réalisée en un matériau à base d'(Al,In,Ga)N ou d'InP.

Le procédé de fabrication peut comporter une ou plusieurs des étapes suivantes : réaliser la portion semiconductrice à porosifier, en forme de mésa, à partir d'un substrat de croissance ; réaliser la diode à partir de la portion semiconductrice à porosifier ; reporter la diode et la portion semiconductrice à porosifier sur un substrat de commande ; effectuer la porosification électrochimique de la portion semiconductrice.

L'invention porte également sur un dispositif optoélectronique, comportant : au moins une diode photoémettrice ou photoréceptrice présentant une face avant destinée à transmettre ou recevoir un rayonnement lumineux ; au moins un composant optique de mise en forme du rayonnement lumineux, situé sur la face avant et recouvrant la diode, et présentant une variation latérale d'indice optique prédéfini, réalisé en un matériau cristallin transparent, et présentant une variation latérale d'un taux de porosité du matériau cristallin transparent.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, en coupe transversale (fig.1A) et en vue de dessus (fig.1B), d'un dispositif optoélectronique selon un premier mode de réalisation, où les composants optiques sont obtenus par porosification électrochimique de portions semiconductrices présentant une variation latérale du niveau de dopage ;
la figure 2 est une vue schématique et partielle, en coupe transversale, d'un dispositif optoélectronique selon un deuxième mode de réalisation, où les composants optiques sont obtenus par porosification électrochimique avec modulation de la tension d'anodisation Eₐ ;
les figures 3A à 3F illustrent différentes étapes d'un procédé de fabrication d'un dispositif optoélectronique similaire à celui de la fig.1A ;
les figures 4A à 4C illustrent différentes étapes d'une variante d'un procédé de fabrication d'un dispositif optoélectronique similaire à celui de la fig.1A ;
les figures 5A à 5C illustrent différentes étapes d'un procédé de fabrication d'un dispositif optoélectronique similaire à celui de la fig.2 ;
les figures 6A à 6D illustrent différentes étapes d'une variante d'un procédé de fabrication d'un dispositif optoélectronique similaire à celui de la fig.2 ;
les figures 7A et 7B sont des vues schématiques et partielles, en coupe transversale (fig.7A) et en vue de dessus (fig.7B), d'un dispositif optoélectronique selon une variante du premier mode de réalisation ;
la figure 8 est une vue schématique et partielle, en coupe transversale, d'un dispositif optoélectronique selon une autre variante du premier mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif optoélectronique, et son procédé de fabrication, comportant au moins une diode, et de préférence une matrice de diodes, au moins un composant optique planaire, recouvrant au moins la diode, adapté à mettre en forme le rayonnement lumineux émis ou reçu par la diode, ce composant optique présentant une variation latérale Δ_{xy}ñ d'indice optique ñ obtenue par porosification électrochimique. La mise en forme du rayonnement lumineux correspond ainsi à un retard de phase local appliqué au rayonnement lumineux, induit par cette variation latérale Δ_{xy}ñ d'indice optique, de sorte que le rayonnement lumineux émis est mis en forme par réfraction. Le rayonnement lumineux peut être en outre soumis à des phénomènes physiques concurrents au passage du composant optique planaire, tels que des phénomènes de diffusion ou de diffraction, n'impactant qu'à la marge la puissance optique du rayonnement lumineux transmis, par exemple moins de 25 % de sa puissance totale, ou moins de 10 %.

Selon l'invention, le composant optique est réalisé par porosification électrochimique d'une portion semiconductrice transparente, où la variation latérale Δ_{xy}p du taux de porosité p(x,y) se traduit par une variation latérale Δ_{xy}ñ voulue de l'indice optique ñ. La portion semiconductrice ainsi porosifiée forme donc le composant optique.

Le taux de porosité p(x,y) (ou taux de porosification) est défini ici comme le rapport entre le volume des pores (volume du vide) sur le volume considéré du composant optique, ce volume considéré interceptant au moins 5 pores, et de préférence au moins 10 pores. Il présente une valeur locale mesurée dans le composant optique, qui peut varier entre une valeur minimale (0 lorsqu'il ne comprend pas de pores : absence de porosification) et une valeur maximale (1 lorsqu'il est entièrement porosifié).

Le taux de porosité p(x,y) varie latéralement de manière discrète (par paliers) ou de manière continue. On note Δ_{xy}p sa variation latérale dans le plan XY, c'est-à-dire dans un plan parallèle à la face avant de la ou des diodes. Elle peut présenter un extremum situé sur l'axe central du composant optique (qui peut être coaxial avec l'axe optique de la diode sous-jacente) et un extremum situé en bordure latérale. Elle peut également présenter des valeurs différentes par zones adjacentes, de type QR-code. Ces différents exemples sont décrits plus loin en référence aux figures.

La variation latérale d'une grandeur peut être décrite comme l'écart de cette grandeur dans le plan XY par rapport à une valeur de référence, par exemple égale à la moyenne de cette grandeur dans ce plan. Son amplitude, exprimée en pourcentage, est définie comme l'écart entre ses extrema opposés, rapporté à cette valeur de référence.

De manière analogue, on définit une variation en épaisseur d'une grandeur. Celle-ci peut être décrite comme l'écart que présente cette grandeur le long d'une direction orthogonale au plan XY par rapport à une valeur de référence, par exemple égale à la moyenne de cette grandeur selon cette direction au point considéré du plan XY. Son amplitude, exprimée en pourcentage, est définie comme l'écart entre ses extrema opposés le long de cette direction, rapporté à cette valeur de référence.

De préférence, le taux de porosité p(x,y) est constant suivant l'épaisseur du composant optique. Le taux de porosité p(x,y) peut présenter une variation en épaisseur résiduelle induite par le procédé de fabrication. Le cas échéant, son amplitude est typiquement inférieure ou égale à 4 % en valeur absolue, en tout point (x, y). Autrement dit, le taux de porosité p(x,y) présente de préférence une variation seulement latérale et non pas également verticale, de sorte que l'on peut noter p(x,y). Toutefois, en variante, une variation verticale Δ_{z}p du taux de porosité p(x,y,z) peut également être obtenue.

L'indice optique ñ(x,y) du composant optique est alors un indice optique 'effectif' ou 'moyen', typiquement moyenné dans un volume de dimensions de l'ordre de la longueur d'onde d'intérêt, dont la valeur locale dépend de celle du taux de porosité p(x,y). Il est défini comme le rapport de l'indice optique n₀ du matériau intègre ou dense du composant optique et du taux de porosité p(x,y) : ñ(x,y) = (1 - n₀) × p(x,y) + n₀. Pour assurer une fonction de mise en forme d'un rayonnement lumineux, notamment dans un but d'en modifier sa divergence, convergence et/ou sa direction, il est généralement admis que les amplitudes de variations latérales du taux de porosité p(x,y) et de l'indice optique effectif ñ(x,y) nécessaires sont typiquement supérieurs ou égales à 5 %.

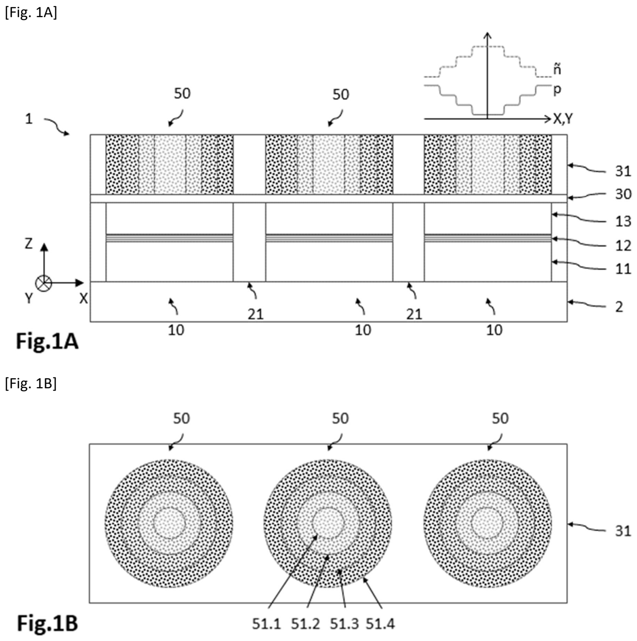

Les figures 1A et 1B sont des vues schématiques et partielles, en coupe transversale (fig.1A) et en vue de dessus (fig.1B), d'un dispositif optoélectronique 1 selon un premier mode de réalisation.

D'une manière générale, les diodes 10 peuvent être des diodes émissives de sorte que le dispositif optoélectronique 1 peut être par exemple un écran d'affichage ou un système d'éclairage. Elles peuvent ainsi être des diodes électroluminescentes de type organique (OLED) ou inorganique (LED). En variante, les diodes peuvent être détectrices de sorte que le dispositif optoélectronique peut être un photodétecteur matriciel. Il peut s'agit de photodétecteurs organiques ou inorganiques. Dans cet exemple, les diodes 10 sont des diodes électroluminescentes.

On définit ici et pour la suite de la description un repère direct tridimensionnel orthogonal XYZ, où les axes X et Y forment un plan principal dans lequel s'étend la matrice de diodes 10, et où l'axe Z est orienté suivant l'épaisseur de la matrice de diodes 10 en direction des composants optiques 50. Les termes 'inférieur' et 'supérieur' sont définis par rapport à un positionnement croissant suivant la direction +Z.

Le dispositif optoélectronique 1 comporte un substrat de commande 2, une matrice de diodes électroluminescentes 10, et des composants optiques 50 qui recouvrent les diodes 10, chaque composant optique 50 étant ici planaire et à variation latérale Δ_{xy}ñ d'indice optique ñ obtenue par porosification électrochimique.

Le substrat de commande 2 comporte un circuit de commande de type CMOS (non représenté), et présente des plots de connexion électrique (non représentés) qui affleurent la face supérieure et viennent au contact de portions conductrices inférieures des diodes 10. Ces portions conductrices inférieures sont ici des portions distinctes les unes des autres, dans le sens où chaque diode 10 est électriquement distincte de la diode adjacente, et peut être polarisée indépendamment de ses voisines. Cette configuration est décrite en détail dans le document WO 2017/194845 A1. D'autres configurations sont possibles.

Les diodes 10 sont ici des diodes électroluminescentes inorganiques. Elles peuvent être réalisées de manière classique, par exemple par épitaxie de couches semiconductrices à partir d'un substrat de croissance, puis par report sur le substrat de commande. Chaque diode 10 peut être formée d'un empilement de : une portion semiconductrice inférieure 11 (située du côté du substrat de commande 2) dopée d'un premier type de conductivité, par exemple de type P ; une zone active 12 où est émis le rayonnement lumineux de la diode électroluminescente ; et une portion semiconductrice supérieure 13 dopée d'un deuxième type de conductivité, par exemple de type N. Les diodes 10 peuvent être réalisées à partir d'un même composé semiconducteur, par exemple à base d'un composé III-V, comme par exemple de l'InP, et de préférence à base d'un composé III-N tel que du GaN, de l'InGaN, ou de l'AlGaN.

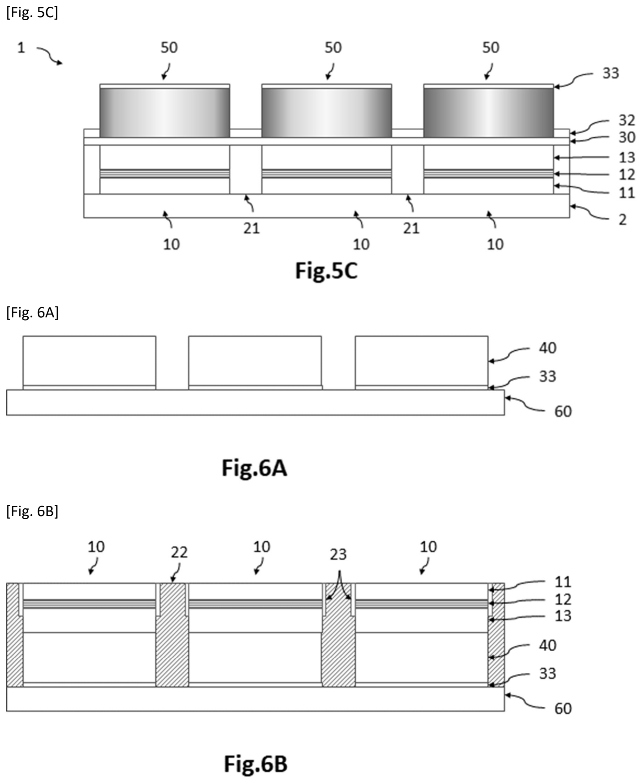

Dans cet exemple, les diodes 10 sont structurellement identiques, de sorte que le rayonnement lumineux émis est identique d'une diode à l'autre en termes de longueur d'onde. Ici, les diodes 10 peuvent être adaptées à émettre un rayonnement lumineux dans le bleu, c'est-à-dire dont le spectre d'émission présente un pic d'intensité à une longueur d'onde comprise entre 440nm et 490nm environ. En variante (comme décrit en référence à la fig.6A et suivantes), les diodes peuvent émettre à des longueurs d'onde différentes. Les diodes sont ici séparées deux à deux dans le plan XY, et l'espace interdiode peut être rempli par un matériau de remplissage 21 électriquement isolant venant au contact de la bordure latérale des portions 11, 12 et 13.

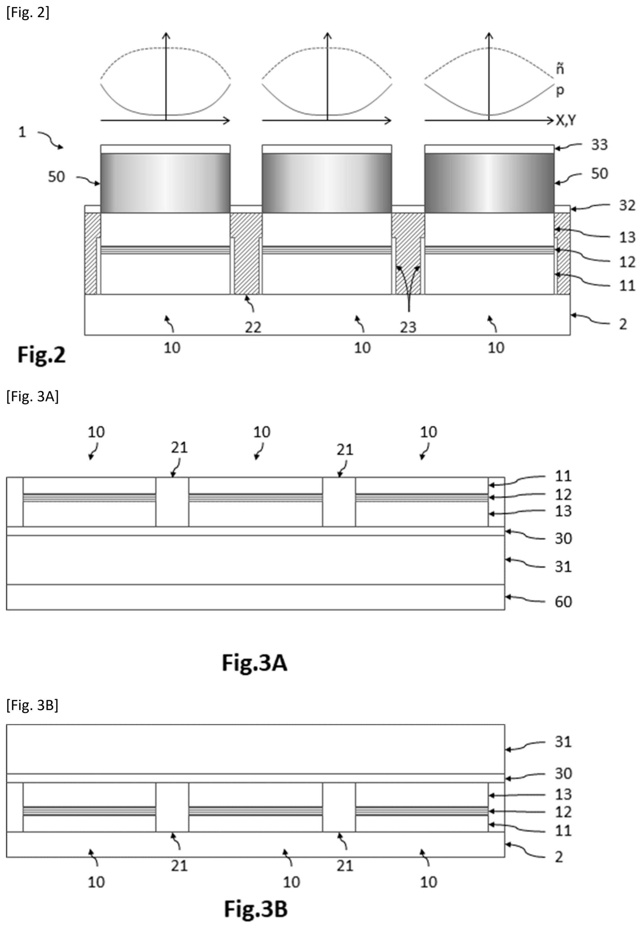

Les diodes 10 sont polarisées électriquement par le substrat de commande 2. Ainsi, les portions 11 dopées de type P sont en contact électrique avec des plots conducteurs sous-jacents (non représentés). Par ailleurs, les portions 13 dopées de type N peuvent être polarisées de différentes manières. La fig.1A illustre un exemple où elles sont polarisées par le biais d'une couche mince conductrice transparente 30, qui s'étend au-dessus des diodes 10 et sous les composants optiques 50, ici réalisée à base d'un composé semiconducteur III-V dopé de type N. Cette couche mince conductrice 30 de polarisation peut être raccordée au substrat de commande 2 par un ou des vias conducteurs (non représentés) situés entre les diodes 10, ou situés en bordure latérale de la matrice de diodes 10. La fig.2 illustre un autre exemple où les portions 13 dopées de type N sont polarisées latéralement par un matériau conducteur 22, situé dans l'espace interdiode, qui vient au contact de la bordure latérale des portions 13 dopées de type N. Une couche mince isolante 23 est située entre ce matériau conducteur 22 et la bordure latérale des zones actives 12 et des portions 11 dopées de type P. D'autres exemples de polarisation sont possibles.

Le dispositif optoélectronique comporte des composants optiques planaires à variation latérale d'indice optique ñ(x,y), qui recouvrent chacun au moins une diode sous-jacente. Dans cet exemple, chaque diode est recouverte par un composant optique.

Le composant optique 50 présente ici des dimensions de longueur et largeur dans le plan XY sensiblement égale à celles de la diode 10 sous-jacente. En variante, les dimensions du composant optique 50 peuvent être supérieures ou inférieures à celles de la diode 10.

Le composant optique 50 est ici planaire dans la mesure où il présente une face supérieure, opposée à la face avant des diodes 10, plane. Elle est de préférence parallèle à la face avant, et de préférence, les faces supérieures des composants optiques 50 sont coplanaires. Ils présentent donc ici tous la même épaisseur, facilitant ainsi l'intégration d'éléments supplémentaires.

Le composant optique 50 est formé d'au moins un matériau semiconducteur transparent dans la bande spectrale d'émission ou de détection des diodes 10. Il s'agit d'un matériau cristallin qui a été porosifié par anodisation électrochimique. Il peut s'agir d'un composé nitrure du type (Al,In,Ga)N, c'est-à-dire d'un composant AlₓIn_{y}Ga_{z}N, où x+y+z=1 avec 0≤x≤1, 0≤y≤1 et 0≤z≤1. De préférence, x est inférieur ou égal à 0,75, voire inférieur ou égal à 0,5. Il peut également s'agir d'InP. Notons que la couche mince conductrice 30 de polarisation peut être formée en un matériau similaire, par exemple en un composé de type AlₓIn_{y}Ga_{z}N, dopé de type N. Il présente un niveau de dopage N_{D} suffisant pour permettre la polarisation électrique des portions 13 dopées de type N, mais insuffisant pour subir une porosification électrochimique. A cet effet, un dopage par des atomes de germanium est préféré. La concentration en atomes de germanium peut être inférieure ou égale à 1E22 at/cm³, préférentiellement inférieure ou égale à 1E21 at/cm³. Pour un dopage avec des atomes de silicium, la concentration en atomes de silicium peut être inférieure ou égale à 1,5E19 at/cm³. La couche mince conductrice 30 est d'autant plus conductrice que le niveau de dopage N_{D} est élevé.

Chaque composant optique 50 présente une variation latérale Δ_{xy}ñ d'indice optique ñ. Comme défini précédemment, l'indice optique ñ est un indice optique 'effectif' qui est défini par la relation ñ(x,y) = (1 - n₀) × p(x,y) + n₀. L'indice optique n₀ présente une valeur constante dans la gamme spectrale d'émission ou de détection des diodes. Dans le cas du GaN, l'indice optique n₀ est égal à 2.4 environ.

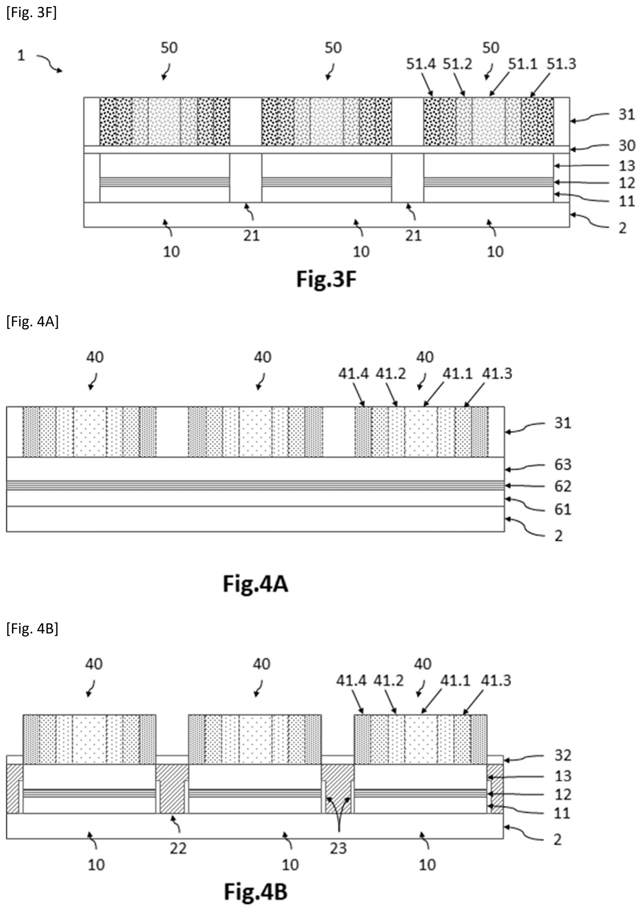

Dans l'exemple de la fig.1A, la variation latérale Δ_{xy}p du taux de porosité p(x,y) a été obtenue par porosification électrochimique localisée de portions semiconductrices 40 transparentes (cf. fig. 3F), ici des parties d'une même couche semiconductrice continue 31. Chaque portion semiconductrice 40 présentait une variation latérale Δ_{xy}N_{D} du niveau de dopage N_{D}, qui se traduit par une variation latérale Δ_{xy}p du taux de porosité p, et donc par la variation latérale Δ_{xy}ñ voulue de l'indice optique ñ. Les étapes du procédé de fabrication sont détaillées plus loin en référence aux fig.3A et suivantes.

Le taux de porosité p(x,y) varie dans le plan XY de manière discrète, et présente des zones concentriques 51.1, 51.2, 51.3, 51.4, centrées sur un axe optique central de la diode 10 et du composant optique 50, à l'intérieur desquelles il présente une valeur sensiblement constante. Elles s'étendent sur sensiblement toute l'épaisseur du composant optique 50. Dans cet exemple, quatre zones concentriques sont représentées, mais le composant optique 50 peut présenter un nombre plus important, ou moins important, de zones, lesquelles peuvent être agencées de différentes manières et présenter différentes dimensions dans le plan XY. Ici, ces zones concentriques sont formées d'une zone centrale 51.1, qui présente ici un taux de porosité p minimal et donc un indice optique ñ maximal, puis d'une succession de zones annulaires 51.2, 51.3, 51.4 qui s'étendent à partir de la zone centrale 51.1 jusqu'à la bordure latérale du composant optique 50, où le taux de porosité p augmente d'une zone à l'autre et donc où l'indice optique ñ diminue en conséquence.

Les composants optiques 50 sont ici des parties de la même couche semiconductrice 31, qui s'étend de manière continue au-dessus de la matrice de diodes 10, en étant ici au contact de la couche mince conductrice 30 de polarisation. Les parties de la couche semiconductrice continue 31, situées entre les composants optiques 50, sont ici non porosifiées, mais elles pourraient l'être.

Ainsi, par les composants optiques 50 dont la variation latérale Δ_{xy}p du taux de porosité p, et donc la variation latérale Δ_{xy}ñ de l'indice optique ñ, est obtenue par porosification électrochimique, on évite ainsi les contraintes que présentent les procédés de fabrication des microlentilles décrits précédemment en référence à l'art antérieur, et notamment les limitations liées aux étapes de fluage et de transfert de forme dans le matériau transparent. De plus, de tels composants optiques 50 présentent de nombreux degrés de liberté de fabrication, permettant d'ajuster, selon les applications visées, leurs propriétés optiques de mise en forme du faisceau lumineux transmis. Ces degrés de liberté sont notamment le choix de la variation latérale Δ_{xy}N_{D} du niveau de dopage N_{D} dans les portions semiconductrices 40 à porosifier et/ou le choix des conditions opératoires lors de l'étape de porosification électrochimique, notamment la valeur ou la modulation de la tension d'anodisation Eₐ. Par ailleurs, les composants optiques 50 sont de préférence planaires, facilitant ainsi l'intégration d'éléments supplémentaires, optiques ou non, après la réalisation des composants optiques.

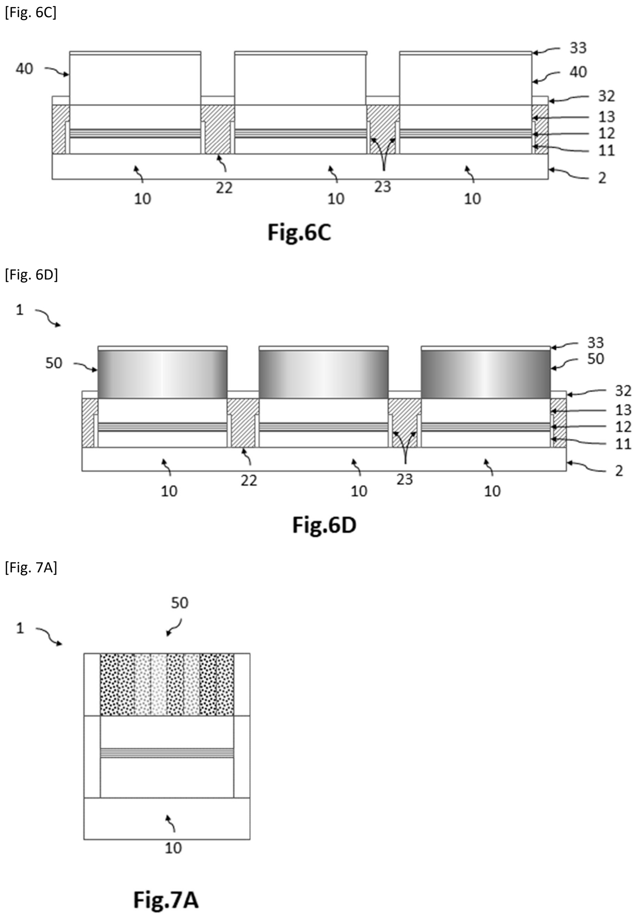

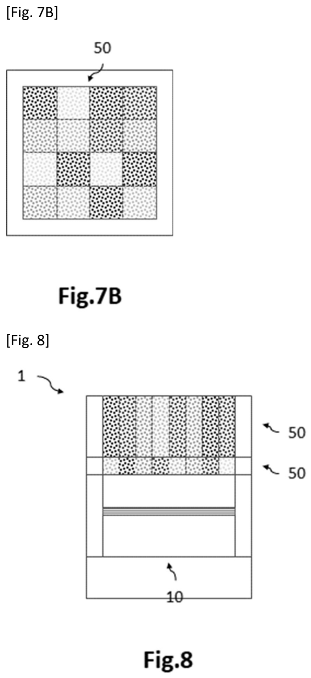

Les composants optiques 50 peuvent former des microlentilles convergentes ou divergentes, avec un axe optique qui peut être coaxial (ou non) avec l'axe optique de la diode. Comme décrit plus loin en référence aux figures 7A, 7B et 8, les composants optiques 50 peuvent former des métasurfaces (de type « QR-code »).

Les composants optiques 50 peuvent être destinés à transmettre le faisceau lumineux en espace libre. Ils peuvent également être couplés à un guide optique, par exemple une fibre optique, dans le cadre notamment d'une application de télé- ou data-communication.

Notons également que la porosité des composants optiques 50 permet d'y incorporer un matériau (résine colorée) ou des éléments semiconducteurs de conversion de couleur, tels que des boîtes quantiques (*Quantum Dots,* en anglais). Le cas échéant, la formule liant le taux de porosification à l'indice optique effectif prend en compte le remplacement de l'air ou du vide par le matériau incorporé, de sorte que ñ(x,y) est égal à (nₘ - n₀) × p(x,y) + n₀, où nₘ est l'indice optique de ce matériau incorporé.

La figure 2 est une vue schématique et partielle, en coupe transversale, d'un dispositif optoélectronique 1 selon un deuxième mode de réalisation. Le dispositif optoélectronique 1 diffère de celui de la fig.1A essentiellement en ce que les composants optiques 50 présentent une variation latérale Δ_{xy}p continue, et non pas discrète, du taux de porosité p et donc de l'indice optique ñ.

Les composants optiques 50 sont ici distincts les uns des autres dans le plan XY, et ne font pas partie d'une même couche semiconductrice continue en un même matériau. Chaque composant optique 50 présente donc, dans le plan XY, une bordure latérale libre (non recouverte), par laquelle la porosification électrochimique a été réalisée.

Le taux de porosité p varie dans le plan XY de manière continue, donc également l'indice optique ñ. Dans cet exemple, le taux de porosité p présente une valeur maximale en bordure latérale des composants optiques 50 et une valeur minimale au centre. Le gradient latéral est ici différent d'un composant optique à l'autre. Notons que d'autres variations latérales sont tout à fait possibles.

Dans le but d'obtenir une variation essentiellement latérale et non pas verticale du taux de porosité p et donc de l'indice optique ñ, chaque composant optique 50 comporte une couche mince de protection 33, qui s'étend sur la face supérieure. Elle peut être en oxyde de silicium. Elle est réalisée de préférence en un matériau similaire à celui des composants optiques 50, c'est-à-dire ici en AlₓIn_{y}Ga_{z}N ou en InP, mais n'est pas ou peu dopé de sorte qu'elle n'a pas été porosifiée lors de l'étape de porosification électrochimique.

Ici, les portions 13 dopées de type N sont polarisées de manière latérale par un matériau conducteur 22, par exemple métallique tel que du cuivre, situé dans l'espace interdiode. Comme indiqué précédemment, une couche mince latérale 23, réalisée en un matériau électriquement isolant, s'étend sur la bordure latérale de la zone active 12 et de la portion 11 dopée de type P, pour isoler celles-ci du matériau conducteur 22. Dans le but de ne pas détériorer ce matériau conducteur 22 lors de l'étape de porosification électrochimique, une couche mince de protection 32 s'étend entre les composants optiques 50 et recouvre le matériau conducteur 22 dans l'espace interdiode. Cette couche mince de protection 32 évite que l'électrolyte liquide ne vienne au contact du matériau conducteur 22.

Les figures 3A à 3F illustrent différentes étapes d'un procédé de fabrication d'un dispositif optoélectronique similaire à celui de la fig.1A. Ici, la variation latérale Δ_{xy}p du taux de porosité p est obtenue par la réalisation préalable d'une variation latérale Δ_{xy}N_{D} du niveau de dopage N_{D} dans les portions semiconductrices 40. Par ailleurs, l'étape de pixellisation des diodes 10 est réalisée avant l'étape de report sur le substrat de commande 2.

En référence à la fig.3A, on réalise une matrice de diodes 10 à partir d'un substrat de croissance 60. Le substrat de croissance 60 peut être un substrat épais (*wafer* en anglais) par exemple en silicium, saphir ou autre, recouvert par exemple d'une couche de nucléation (non représentée). La couche semiconductrice continue 31 est réalisée ensuite par épitaxie à partir de la couche de nucléation. Dans cet exemple, elle peut être réalisée en GaN pas ou peu dopé de type N, par exemple non intentionnellement dopé. Cette couche semiconductrice continue 31 est destinée à former les portions semiconductrices 40 et donc ensuite les composants optiques 50.

La couche semiconductrice continue 31 est recouverte par une couche mince conductrice 30, réalisée ici en un matériau semiconducteur cristallin dopé de type N, par exemple en GaN, par épitaxie à partir de la couche semiconductrice continue 31. La couche mince conductrice 30 est destinée à assurer la polarisation électrique des portions 13 dopées de type N des diodes 10. Cependant, son niveau de dopage est choisi pour ne sensiblement pas subir de porosification lors de l'étape ultérieure d'anodisation électrochimique.

Les diodes 10 sont réalisées par épitaxie d'une couche semiconductrice dopée de type N, puis d'une couche active pouvant comporter des puits quantiques, et d'une couche semiconductrice dopée de type P. Cet empilement est ensuite pixellisé pour former la matrice de diodes 10. Un matériau de remplissage 21, ici électriquement isolant, remplit l'espacement interdiode.

En référence à la fig.3B, on reporte l'empilement sur un substrat de commande 2, puis on supprime le substrat de croissance, de manière à rendre libre la face supérieure de la couche semiconductrice continue 31. Le substrat de commande 2 comporte des plots conducteurs (non représentés) situés sous et au contact électrique des portions 11 dopées de type P, et un ou des plots conducteurs (non représentés) en contact électrique avec la couche mince conductrice 30 pour la polarisation des portions 13 dopées de type N.

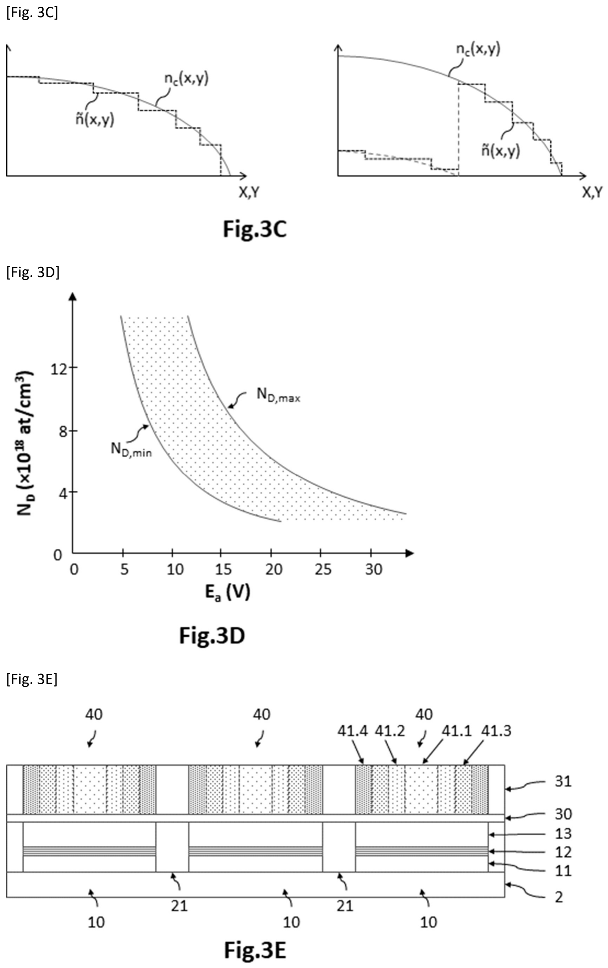

En référence à la fig.3C, la fig.3D et la fig.3E, on réalise une variation latérale Δ_{xy}N_{D} du niveau de dopage N_{D}(x,y) dans des parties de la couche semiconductrice continue 31, pour ainsi former des portions semiconductrices 40 dopées destinées à former, une fois porosifiées, les composants optiques 50. Ici, cette distribution spatiale du niveau de dopage N_{D}(x,y) est effectuée par implantation ionique. Toutefois, dans le cas où la couche semiconductrice continue 31 avait été dopée de type N à la croissance, cette distribution spatiale du niveau de dopage N_{D}(x,y) peut être réalisée par dédopage localisé, comme indiqué notamment dans le document WO 2024/134081 A1.

Au préalable, on détermine une loi de phase souhaitée ϕ(x,y) du composant optique 50, correspondant au retard de phase que l'on souhaite appliqué au faisceau lumineux émis. Cette loi de phase dépend du type de composant optique souhaité et de ses propriétés de mise en forme du faisceau lumineux émis par la diode 10 sous-jacente. On en déduit une variation latérale Δ_{xy}n_{c} d'indice optique cible n_{c}(x,y) à partir de la relation : n_{c}(x,y) = λ/(2π×h) × ϕ(x,y), où λ est une longueur d'onde centrale du spectre d'émission de la diode et où h est l'épaisseur de la portion semiconductrice 40 à porosifier. Exprimé ainsi, n_{c}(x,y) correspond à l'indice optique nécessaire pour appliquer un retard de phase égal à la loi de phase souhaitée ϕ(x,y) à une onde plane traversant la portion semiconductrice 40 à incidence normale. Ceci est notamment le cas lorsque le faisceau lumineux est émis par recombinaison de porteurs dans des puits quantiques de la diode 10, et que ces puits quantiques s'étendent parallèlement aux faces inférieure et supérieure de la portion semiconductrice 40. Sur la fig.3C, cette variation cible n_{c}(x,y) est représentée en trait linéaire continu (sans paliers).

On détermine ensuite une variation latérale discrète Δ_{xy}ñ de l'indice optique final ñ(x,y), et donc du taux de porosité p(x,y), qui s'ajuste (*curve fitting,* en anglais) à la variation latérale d'indice optique cible n_{c}(x,y). Cette variation Δ_{xy}ñ est ici discrète, et est représentée sur la fig.3C en trait pointillé à paliers. On en déduit alors la variation latérale Δ_{xy}p correspondante du taux de porosité p(x,y) : p(x,y) = (ñ(x,y) - n₀) / (1 - n₀). Notons, comme l'illustre le graphe de droite de la fig.3C, que, si les valeurs élevées de l'indice optique cible n_{c} sont supérieures à l'indice du matériau intègre, ici du GaN (n₀=2.4), il est possible d'adapter la variation latérale Δ_{xy}n_{c} de l'indice optique cible n_{c}(x,y) par une modulation par 2π de la loi de phase ϕ.

La fig.3D représente un exemple de relation entre le niveau de dopage N_{D} d'une couche cristalline dopée en fonction de la tension électrique d'anodisation Eₐ appliquée, mettant en évidence le domaine d'existence de la porosification électrochimique. Un tel exemple est décrit notamment dans le document EP 3 840 016 A1. En deçà d'un niveau de dopage minimal N_{D,min} et à faible tension d'anodisation Eₐ, le régime est celui de la formation de canaux et non pas celui d'une porosification. Il est dit *pre-breakdown.* A l'opposé, au-delà d'un niveau de dopage maximal N_{D,max} et à forte tension d'anodisation Eₐ, le régime est celui de la gravure par électropolissage du matériau. Entre ces deux régimes existe le régime de la porosification électrochimique. Ainsi, ce type d'abaque donne la relation entre le niveau de dopage N_{D} nécessaire, pour une tension d'anodisation Eₐ donnée, et le taux de porosité p. En effet, à niveau de dopage constant, le fait d'augmenter la tension d'anodisation Eₐ conduit à augmenter le taux de porosité p. De même, à tension d'anodisation Eₐ constante, augmenter le niveau de dopage conduit à augmenter le taux de porosité p. Connaissant donc la variation spatiale Δ_{xy}p qui a été déterminée, on en déduit la variation spatiale correspondante Δ_{xy}N_{D} du niveau de dopage, pour une tension d'anodisation Eₐ donnée. Le taux de porosification peut ainsi varier sur une grande plage de valeurs, par exemple comprise entre 1 % et 70 %, ou entre 5 % et 65 %.

Enfin, comme l'illustre la fig.3E, on réalise la distribution spatiale Δ_{xy}N_{D} déterminée dans chaque portion semiconductrice 40, ici par implantation ionique. Dans cet exemple, on a plusieurs zones concentriques 41.1, 41.2..., centrées sur l'axe optique de chaque portion semiconductrice 40 (coaxial ici avec celui de la diode 10 sous-jacente), où le niveau de dopage N_{D} est sensiblement homogène dans le plan XY et suivant la direction Z. Les portions semiconductrices 40 sont distinctes deux à deux, et sont ici séparées par une zone non intentionnellement dopée.

En référence à la fig.3F, on réalise les composants optiques 50, par porosification électrochimique des zones dopées 41 des portions semiconductrices 40. Pour cela, on met la face libre de la couche semiconductrice continue 31 (et donc des portions semiconductrices 40) au contact d'un électrolyte liquide. L'électrolyte liquide peut être acide ou basique, et peut être de l'acide oxalique. Il peut également s'agir de HCl, KOH, HF, HNO₃, NaNO₃, H₂SO₄ ou de leur mélange. On peut ainsi utiliser également un mélange d'acide oxalique et de NaNO₃. La structure est connectée électriquement à un générateur électrique, ici par exemple par le biais de la couche mince conductrice 30 qui permet de polariser les portions semiconductrices 41 à porosifier. La couche mince conductrice 30 forme alors une électrode de travail, ici raccordée à l'anode du générateur électrique. Une contre-électrode (ici une grille en platine) est plongée dans l'électrolyte, et est raccordée à la cathode du générateur électrique. Le générateur électrique applique une tension d'anodisation Eₐ. Ainsi, les zones dopées 41 des différentes portions semiconductrices 40 sont porosifiées, chacune en fonction du niveau de dopage, se traduisant par un taux de porosité p propre à chaque zone dopée. Les portions semiconductrices 40 alors porosifiées présentent donc la variation latérale Δ_{xy}p voulue du taux de porosité p(x,y), et donc la variation latérale d'indice optique ñ(x,y), formant ainsi les composants optiques 50. L'amplitude de la variation latérale Δ_{xy}p voulue est typiquement supérieure ou égale à 5 %, voire supérieure ou égale à 10 %, cette valeur dépendant notamment de l'épaisseur h, de la nature du matériau de la portion semiconductrice 40 et de la loi de phase ϕ(x,y) souhaitée.

Les figures 4A à 4C illustrent différentes étapes d'une variante du procédé de fabrication des figures 3A-3F, qui s'en distingue essentiellement par le fait que l'étape de pixellisation des diodes 10 est réalisée après l'étape de dopage localisé des portions semiconductrices 40 à porosifier.

La figure 4A est similaire à celle de la fig.3E, à ceci près que les diodes 10 n'ont pas encore été pixellisées. Ainsi, un empilement de couches semiconductrices a été reporté sur le substrat de commande 2. Cet empilement comporte, à partir du substrat de commande 2, une couche semiconductrice 61 dopée de type P, une couche active 62, une couche semiconductrice 63 dopée de type N, et enfin la couche semiconductrice continue 31. Celle-ci comporte les portions semiconductrices 40 à dopage localisé, destinées à être porosifiées pour former les composants optiques 50.

En référence à la fig.4B, on réalise une pixellisation des portions semiconductrices 40 à dopage localisé ainsi que des diodes 10. Pour cela, on réalise une gravure localisée de la couche semiconductrice continue 31, et des couches semiconductrices 63, 62, 61, pour déboucher ici sur le substrat de commande. Les portions semiconductrices 40 à dopage localisé sont ainsi rendues distinctes les unes des autres, ainsi que les diodes 10.

On réalise ensuite les « contacts N », par dépôt d'une couche mince latérale 23, recouvrant les bordures latérales des portions 11 dopées de type P et les portions actives 12, puis par dépôt d'un matériau métallique 22 venant au contact de la bordure latérale des portions 13 dopées de type N. Une couche mince de protection 32, inerte lors de l'étape de porosification électrochimique, peut être déposée sur le matériau métallique 22, entre les portions semiconductrices 40 à dopage localisé, de manière à le protéger de toute dégradation lors de la porosification électrochimique.

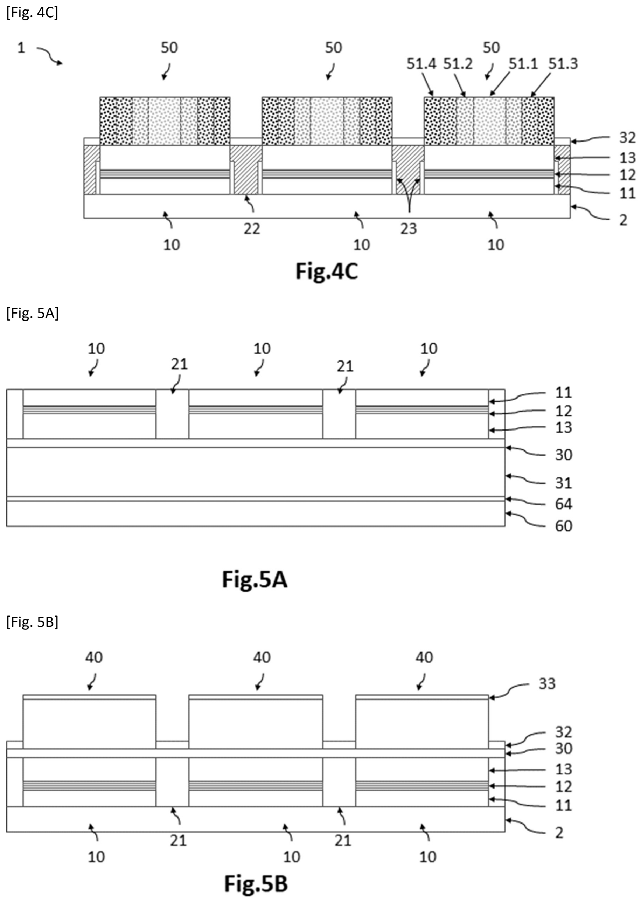

En référence à la fig.4C, on réalise ensuite les composants optiques 50, par porosification électrochimique des portions semiconductrices 40 à dopage localisé. La polarisation électrique de celles-ci est effectuée ici par le biais des portions 13 dopées de type N, polarisées via le « contact N » et le substrat de commande 2. Elle pourrait également être effectuée par le biais de la jonction semiconductrice, comme dans la demande de brevet FR3143850 A1 publiée le 21/06/2024, de numéro d'enregistrement national FR2213826, et déposée le 19/12/2022. Les portions semiconductrices 40 alors porosifiées présentent donc la variation latérale Δ_{xy}p du taux de porosité p(x,y) souhaitée, et donc la variation latérale Δ_{xy}ñ de l'indice optique ñ(x,y). Elles forment donc les composants optiques 50.

Les figures 5A à 5C illustrent différentes étapes d'un procédé de fabrication d'un dispositif optoélectronique 1 similaire à celui de la fig.2. Ce procédé se distingue de celui des figs.3A-3F et 4A-4C essentiellement en ce que la variation latérale Δ_{xy}p du taux de porosité p(x,y) est obtenue par une modulation de la tension d'anodisation Eₐ lors de l'étape de porosification électrochimique.

En référence à la fig.5A, on réalise une structure similaire à celle de la fig.3A. Elle comporte un substrat de croissance 60, une couche mince semiconductrice de protection 64, la couche semiconductrice continue 31, une couche mince conductrice 30, et la matrice de diodes 10. Dans cet exemple, la polarisation des portions 13 dopées de type N est assurée par la couche mince conductrice 30. Les diodes 10 sont séparées deux à deux par un matériau de séparation isolant 21. Toutefois, en variante, des « contacts n » similaires à ceux de la fig.2 peuvent être réalisés. La couche semiconductrice continue 31 est dopée de type N, avec un niveau de dopage permettant sa porosification ultérieure. Le niveau de dopage y est sensiblement homogène.

En référence à la fig.5B, on reporte la matrice de diodes 10 sur le substrat de commande 2, et on retire le substrat de croissance 60, de manière à rendre libre la face supérieure de la couche mince de protection 64. On pixellise ensuite les portions semiconductrices 40, par gravure localisée des couches 64 et 31. Les portions semiconductrices 40 présentent alors une bordure latérale ayant une surface libre. Enfin, leur face supérieure est recouverte par une portion mince de protection 33. Une couche mince 32 peut être déposée sur la couche mince conductrice 30, entre les portions semiconductrices 40, de manière à la protéger lors de l'étape de porosification électrochimique.

En référence à la fig.5C, on réalise ensuite les composants optiques 50 par porosification électrochimique des portions semiconductrices 40. Comme le niveau de dopage N_{D} y est sensiblement homogène, la variation latérale Δ_{xy}p du taux de porosité p est obtenue par une modulation de la tension d'anodisation Eₐ, selon l'approche décrite dans la demande de brevet FR2406898, déposée le 27/06/2024.

Pour cela, on met la surface libre de la bordure latérale des portions semiconductrices 40 au contact de l'électrolyte liquide, et on connecte la structure au générateur électrique, ici par exemple par le biais de la couche mince conductrice 30. Comme précédemment, la couche mince conductrice 30 forme alors une électrode de travail, ici raccordée à l'anode du générateur électrique. Une contre-électrode (ici un fil ou une grille en platine) est plongée dans l'électrolyte, et est raccordée à la cathode du générateur électrique. Le générateur électrique applique une tension électrique d'anodisation Eₐ dont la valeur est modulée dans le temps. Autrement dit, on applique plusieurs valeurs de la tension électrique Eₐ de manière à provoquer une porosification des portions semiconductrices 40 à partir de la bordure latérale, et à obtenir la variation latérale voulue Δ_{xy}p du taux de porosité p.

A titre d'exemple, on applique une première tension d'anodisation Eₐ pendant une première durée, puis une deuxième tension d'anodisation Eₐ pendant une deuxième durée. On peut ainsi appliquer différentes valeurs de la tension d'anodisation Eₐ pendant différentes durées. En effet, la mise en œuvre de la porosification électrochimique en plusieurs séquences successives, avec différentes valeurs de tension d'anodisation Eₐ, permet d'obtenir la variation latérale voulue Δ_{xy}p du taux de porosité p des portions semiconductrices 40 dans le plan XY. Il n'est alors pas besoin d'avoir réalisé au préalable une distribution spatiale du niveau de dopage, comme dans les exemples des figures 3A-3F et 4A-4C. Pour cela, on utilise un abaque similaire à celui de la fig.3D où, pour un niveau de dopage initial, la modification de la valeur de la tension d'anodisation Eₐ se traduit par un taux de porosité différent.

Il est possible de réaliser toute sorte de variation spatiale Δ_{xy}p du taux de porosité p. Il est ainsi possible d'obtenir un cœur des composants optiques 50 plus porosifié que la bordure latérale, ou inversement, avec une variation monotone (sens de variation constant) ou non. Notons que la présence des portions minces de protection 33 permet d'éviter que la porosification des portions semiconductrices 40 ne se fasse également à partir de la face supérieure. On obtient ainsi une variation essentiellement latérale du taux de porosité, avec une variation verticale sensiblement nulle. Toutefois, il est possible d'avoir une variation verticale du taux de porosité : pour cela, on ne réalise pas la couche mince de protection 64 (et donc pas de portions minces de protection 33), de manière à rendre libre également la face supérieure des portions semiconductrices.

Notons que, ici, les portions semiconductrices 40 sont polarisées lors de l'étape de porosification électrochimique par la même couche mince conductrice 30. Les composants optiques 50 présentent alors la même variation latérale Δ_{xy}p du taux de porosité p. En variante, dans le cas où les diodes 10 sont polarisées par des « contacts N » similaires à ceux de la fig.2, il est possible de polariser les portions semiconductrices 40 de manière indépendante au cours de l'étape de porosification électrochimique, soit par le biais des « contacts N », soit par le biais de la jonction semiconductrice. Les composants optiques 50 peuvent alors présenter des variations latérales Δ_{xy}p du taux de porosité p différentes d'un composant optique à l'autre.

Les figures 6A à 6D illustrent différentes étapes d'un autre procédé de fabrication d'un dispositif optoélectronique similaire à celui de la fig.2. Dans cet exemple, les portions semiconductrices 40, avant l'étape de porosification électrochimique, présentent une forme de mésa de croissance des diodes 10.

En référence à la fig.6A, on réalise un substrat de croissance 60 recouvert par des portions semiconductrices 40 destinées à être porosifiées. Des portions minces de protection 33 sont réalisées entre le substrat de croissance 60 et les portions semiconductrices 40. Celles-ci sont distinctes les unes des autres dans le plan XY. Elles présentent un dopage de type N, avec un niveau de dopage homogène au sein de chaque portion semiconductrice.

En référence à la fig.6B, on réalise ensuite les diodes 10 à partir de la face supérieure libre des portions semiconductrices 40. Une couche mince de masque de nucléation (non représentée) peut être présente et peut recouvrir la bordure latérale des portions semiconductrices 40 et la face supérieure libre du substrat de croissance 60.

Les diodes peuvent être réalisées de manière séquentielle, l'une après l'autre (par groupe de diodes), dans le cas où elles présentent des propriétés optiques d'émission ou de réception différentes les unes des autres. Pour cela, elles présentent alors, par exemple, un taux d'indium dans les puits quantiques différents pour ainsi émettre, par exemple, les unes dans le vert, les autres dans le rouge, et d'autres enfin dans le bleu.

Enfin, les « contacts N » sont réalisés. Pour cela, la bordure latérale des portions 13 dopées de type N, et de préférence également celle des portions semiconductrices 40, est rendue libre. Un matériau métallique 22 remplit ensuite l'espace interdiode, et vient au contact de la bordure latérale des portions 13 dopées de type N. Une couche mince d'isolation 23 recouvre la bordure latérale des portions actives 12 et des portions 11 dopées de type P, pour éviter le contact électrique avec le matériau métallique 22.

En référence à la fig.6C, on reporte la matrice de diodes 10 sur le substrat de commande 2. Le substrat de croissance 60 est ensuite retiré. Ainsi, la face supérieure des portions minces de protection 33 est rendue libre. La bordure latérale des portions semiconductrices 40 est rendue libre par gravure localisée du matériau métallique 22. Celui-ci est gardé entre les diodes pour assurer la polarisation des portions 13 dopées de type N. Enfin, de préférence, une couche mince de protection 32 est déposée sur le matériau métallique 22, entre les portions semiconductrices 40, de manière à protéger ce dernier (si nécessaire) lors de l'étape de porosification électrochimique.

En référence à la fig.6D, on réalise ensuite les composants optiques 50, par porosification électrochimique des portions semiconductrices 40. Celles-ci présentant un niveau de dopage N_{D} homogène, et présentant une bordure latérale libre, la porosification est effectuée avec modulation de la tension d'anodisation Eₐ. Cette étape est similaire ou identique à celle décrite en lien avec la fig.5C.

Des modes de réalisation particuliers viennent d'être décrits. Différentes variantes et modifications apparaîtront à l'homme du métier.

A ce titre, les figures 7A et 7B sont des vues schématiques et partielles, en coupe transversale (fig.7A) et en vue de dessus (fig.7B), d'un dispositif optoélectronique 1 selon un mode de réalisation. Cet exemple montre que tout type de variation latérale peut être envisagée, notamment des composants optiques 50 de type métasurface où les zones de taux de porosité différents (et donc d'indice optique ñ) sont adjacentes dans le plan XY.

Par ailleurs, la figure 8 est une vue schématique et partielle, en coupe transversale, d'un dispositif optoélectronique 1 selon un autre mode de réalisation. Ici, le dispositif optoélectronique comporte plusieurs composants optiques 50 empilés les uns au-dessus des autres, qui peuvent présenter différentes épaisseurs. Les composants optiques 50 empilés peuvent présenter différentes variations latérales du taux de porosité et donc de l'indice optique.

D'une manière générale, les composants optiques peuvent être bordés d'un matériau de remplissage transparent ou réfléchissant à la lumière transmise. Ils peuvent présenter des dimensions sensiblement égales, supérieures ou inférieures, dans le plan XY, à celles des diodes. Les composants optiques peuvent former des lentilles convergentes, divergentes, ou de mise en forme particulière de la lumière transmise.

## Revendications

1. Procédé de fabrication d'un dispositif optoélectronique (1) comportant : au moins une diode (10) photoémettrice ou photoréceptrice présentant une face avant destinée à transmettre ou recevoir un rayonnement lumineux ; au moins un composant optique (50) de mise en forme du rayonnement lumineux, situé sur la face avant et recouvrant la diode, et présentant une variation latérale d'indice optique effectif ñ(x,y) prédéfinie ;
∘ **caractérisé en ce qu'**il comporte les étapes suivantes :
• fournir la diode (10) ;
• déterminer une variation latérale (Δ_{xy}p) d'un taux de porosité (p) du composant optique (50) fonction de l'indice optique effectif ñ(x,y), à partir d'une variation latérale (Δ_{xy}n_{c}) d'indice optique cible (n_{c}) prédéfinie, d'une portion semiconductrice (40) réalisée en un matériau cristallin transparent au rayonnement lumineux et située sur la face avant et recouvrant la diode (10) ;
• réaliser la portion semiconductrice (40) à porosifier ;
• effectuer une porosification électrochimique de la portion semiconductrice (40), de sorte qu'elle présente la variation latérale (Δ_{xy}p) déterminée du taux de porosité (p), la portion semiconductrice ainsi porosifiée formant alors le composant optique (50).

2. Procédé de fabrication selon la revendication 1, dans lequel la variation latérale (Δ_{xy}p) déterminée du taux de porosité présente une amplitude supérieure ou égale à 5 %.

3. Procédé de fabrication selon la revendication 1 ou 2, dans lequel le composant optique (50) présente une épaisseur, et dans lequel le taux de porosité (p) présente une variation en épaisseur d'amplitude inférieure ou égale à 4 %.

4. Procédé de fabrication selon la revendication 1, dans lequel la portion semiconductrice (40) à porosifier présente une face supérieure plane opposée à la face avant de la diode (10).

5. Procédé de fabrication selon la revendication 1 ou 4, dans lequel :
∘ lors de l'étape de réalisation de la portion semiconductrice (40) à porosifier, celle-ci comporte plusieurs zones dopées (41.1, 41.2...) adjacentes, présentant un niveau de dopage différent d'une zone dopée à l'autre ;
∘ lors de l'étape de porosification électrochimique, les zones dopées (41.1, 41.2) sont porosifiées et présentent un taux de porosité différent d'une zone dopée à l'autre.

6. Procédé de fabrication selon la revendication 5, dans lequel, lors de l'étape de réalisation de la portion semiconductrice (40) à porosifier, chaque zone dopée (41.1, 41.2...) présente un niveau de dopage homogène latéralement et verticalement.

7. Procédé de fabrication selon la revendication 5 ou 6, dans lequel :
∘ le dispositif optoélectronique comporte une matrice de diodes (10) et plusieurs composants optiques (50) formés à partir de portions semiconductrices (40) à porosifier,
∘ lors de l'étape de réalisation des portions semiconductrice (40) à porosifier, celles-ci sont des parties d'une même couche semiconductrice continue (31) s'étendant sur la matrice de diodes (10).

8. Procédé de fabrication selon l'une quelconque des revendications 5 à 7, dans lequel, lors de l'étape de porosification électrochimique, un signal électrique d'anodisation présente une valeur constante dans le temps jusqu'à l'obtention de la variation latérale (Δ_{xy}p) du taux de porosité (p).

9. Procédé de fabrication selon la revendication 1 ou 4, dans lequel lors de l'étape de porosification électrochimique, une modulation en intensité d'un signal électrique d'anodisation (Eₐ) est effectuée, conduisant à l'obtention de la variation latérale (Δ_{xy}p) du taux de porosité (p).

10. Procédé de fabrication selon la revendication 9, dans lequel, lors de l'étape de réalisation de la portion semiconductrice (40) à porosifier, celle-ci présente un niveau de dopage latéralement homogène.

11. Procédé de fabrication selon la revendication 9 ou 10, dans lequel, lors de l'étape de réalisation de la portion semiconductrice (40) à porosifier, celle-ci présente une bordure latérale libre.

12. Procédé de fabrication selon l'une quelconque des revendications 9 à 11, dans lequel, lors de l'étape de réalisation de la portion semiconductrice (40) à porosifier, celle-ci présente une face supérieure recouverte par une portion mince de protection (33) réalisée en un matériau non porosifiable lors de l'étape de porosification électrochimique.

13. Procédé de fabrication selon l'une quelconque des revendications 4 à 12, dans lequel la portion semiconductrice (40) à porosifier est réalisée en un matériau à base d'InP ou d'(Al,In,Ga)N.

14. Procédé de fabrication selon l'une quelconque des revendications 1 à 11, comportant les étapes suivantes :
∘ réaliser la portion semiconductrice (40) à porosifier, en forme de mésa, à partir d'un substrat de croissance (60) ;
∘ réaliser la diode (10) à partir de la portion semiconductrice (40) à porosifier, en forme de mésa ;
∘ reporter la diode (10) et la portion semiconductrice (40) à porosifier sur un substrat de commande (2) ;
∘ effectuer la porosification électrochimique de la portion semiconductrice (40).

15. Dispositif optoélectronique (1), comportant :
∘ au moins une diode (10) photoémettrice ou photoréceptrice présentant une face avant destinée à transmettre ou recevoir un rayonnement lumineux ;
∘ au moins un composant optique (50) de mise en forme du rayonnement lumineux, situé sur la face avant et recouvrant la diode, et présentant une variation latérale d'indice optique effectif prédéfinie ;
∘ **caractérisé en ce que** le composant optique (50) est réalisé en un matériau semiconducteur cristallin transparent, et présente une variation latérale (Δ_{xy}p) d'un taux de porosité (p) du matériau cristallin transparent qui se traduit par la variation latérale d'indice optique effectif prédéfini.
